Europäisches Patentamt

European Patent Office

Office européen des brevets

(11) Veröffentlichungsnummer: **0 388 614**
**A2**

# (12) EUROPÄISCHE PATENTANMELDUNG

(21) Anmeldenummer: 90102223.6

(22) Anmeldetag: 05.02.90

(51) Int. Cl.5: **C08J 3/09, C09D 133/12,**
**//G03F7/039,G03F7/00,**
**C08L33:12**

(30) Priorität: **08.03.89 DE 3907534**

(43) Veröffentlichungstag der Anmeldung:
**26.09.90 Patentblatt 90/39**

(84) Benannte Vertragsstaaten:
**DE FR GB IT**

(71) Anmelder: **Siemens Aktiengesellschaft**
**Wittelsbacherplatz 2**
**D-8000 München 2(DE)**

(72) Erfinder: **Formanek, Helmut, Dr.**
**Römerhofstrasse 51**
**D-8046 Garching(DE)**
Erfinder: **Hintermaier, Magdalena**
**Nockerstrasse 40**
**D-8000 München 90(DE)**
Erfinder: **Knapek, Erwin, Dr.**
**Franz-Schubert-Strasse 26**
**D-8025 Unterhaching(DE)**
Erfinder: **Lischke, Burkhard, Prof.**
**In der Heuluss 13**
**D-8000 München 82(DE)**

(54) Verfahren zum Erzeugen homogener Poly-Methylmethacrylat-Schichten.

(57) Mit Hilfe einer Lösung von Poly-Methylmethacrylat in einem Milchsäureester können glatte homogene PMMA-Schichten von mehr als 20 μm Dicke erzeugt werden. Die PMMA-Schichten sind insbesondere für Mikrostrukturierungstechniken mit ionisierender energiereicher Strahlung geeignet und weisen eine gute Haftung auf metallischen, halbleitenden und isolierenden Substraten auf.

FIG.1

EP 0 388 614 A2

## Verfahren zum Erzeugen homogener Poly-Methylmethacrylat-Schichten.

Die Erfindung betrifft ein Verfahren zum Erzeugen homogener Poly-Methylmethacrylat-Schichten mit einstellbarer Dicke.

Poly-Methylmethacrylat (PMMA) kann als Photolack zur lithographischen Strukturierung mittels ionisierender energiereicher Strahlung verwendet werden. Auf unterschiedlichen Substraten aus metallischen, halbleitenden oder isolierenden Materialien wird dazu eine dünne PMMA-Schicht aufgebracht, in dieser Schicht mit Elektronenstrahlen oder durch Röntgenlithographie ein "Bild" erzeugt, welches nach naßchemischer Entwicklung in eine Struktur aus PMMA überführt wird, welche ein positives Bild darstellt. Die erzeugte PMMA-Struktur kann als Maske für weitere Fertigungsschritte dienen. Insbesondere durch Ätzen, Dotieren oder Abscheiden von beliebigem weiterem metallischem oder anderem Material können so auf dem Substrat gewünschte Strukturen für mikroelektronische und andere Mikro-Bauteile erzeugt werden.

Das Aufbringen von PMMA-Schichten erfolgt wie bei normalem Photolack in Lösung, zum Beispiel durch Auftropfen oder Aufschleudern. Dazu verwendete Lösungsmittel sind zum Beispiel Chlorbenzol oder Methylisobutylketon. Während die Herstellung einfacher dünner Photolackschichten keine Probleme bereitet, ist es mit den bekannten Lösungsmitteln nicht möglich, homogene und glatte Schichten von mehr als 20 $\mu$m Schichtdicke zu erzeugen. Derart dicke Schichten weisen dann eine grieselige Oberfläche auf, die außerdem noch unter mechanischer Spannung steht und zur Rißbildung neigt. Auch wird für größere Schichtdicken eine höher konzentrierte und somit viskosere Lösung von PMMA benötigt, welches sich mit bekannten Lösungsmitteln nicht darstellen läßt. Bislang wurden PMMA-Schichtdicken von mehr als 20 $\mu$m nur durch Verkleben mehrerer dünner PMMA-Folien mit Cyanacrylat-Kleber erreicht. Ein solches Verfahren ist zum einen äußerst aufwendig und zum anderen außerdem sehr kosten-und zeitintensiv.

Eine weitere Möglichkeit, beliebige Strukturen von mehr als 20 $\mu$m Dicke bei gleichzeitig gefordertem hohen Aspektverhältnis zu erzeugen, bietet sich nur noch durch die Verwendung von Zweikomponenten-Reaktionsharzen. Diese Technik ist jedoch unter anderem wegen der komplizierten Mischung und Dosierung der beiden Harz-komponenten äußerst aufwendig.

Aufgabe der vorliegenden Erfindung ist es daher, ein Verfahren zum Erzeugen von PMMA-Schichten anzugeben, welches es erlaubt, besonders homogene Schichten mit einer einstellbaren Schichtdicke größer 20 $\mu$m herzustellen.

Diese Aufgabe wird erfindungsgemäß durch ein Verfahren der eingangs genannten Art gelöst, welches folgende Schritte aufweist:

a) Herstellung einer Lösung von PMMA in Milchsäureester,

b) Aufbringen dieser Lösung in gleichmäßiger Schicht auf ein Substrat,

c) Trocknen der Schicht durch Abdunsten des Lösungsmittels und

d) gegebenenfalls mehrmaliges Wiederholen der Schritte a), b) und c).

Weitere Ausgestaltungen der Erfindung sind den Unteransprüchen zu entnehmen.

Mit dem erfindungsgemäßen Verfahren lassen sich homogene PMMA-Schichten mit glatter Oberfläche in einer Dicke bis ca. 40 $\mu$m erzeugen. Neben der durch bekannte Verfahren bislang nicht erreichten Qualität derartiger Schichten zeichnet sich das erfindungsgemäße Verfahren außerdem durch die Unbedenklichkeit der verwendeten Lösungsmittel aus. Insbesondere gegenüber Chlorbenzol hat Milchsäureester den Vorteil, daß er gesundheitlich unbedenklich und außerdem biologisch abbaubar ist. Dadurch wird auch das Verfahren vereinfacht, da im offenen System gearbeitet werden kann.

Besondere Vorteile werden bei der Verwendung von Milchsäureethylester erzielt. Dieser stellt sich als das mit Abstand beste Lösungsmittel für PMMA dar. Es können homogene Lösungen hergestellt werden, die bis zu 5 Gewichtsprozent PMMA enthalten. Üblicherweise werden jedoch Lösungen mit einem Gehalt bis ca. 1 Gewichtsprozent PMMA verwendet. Die Konzentration der Lösung bestimmt auch die in einem Arbeitsgang erreichbare Schichtdicke. Weitere Möglichkeiten zur Einstellung der Schichtdicke sind durch Auswahl eines anderen Polymerisationsgrades des PMMA-Materials oder durch eine Kontrolle der Drehzahl gegeben, wenn die PMMA-Schicht durch Aufschleudern auf das Substrat erzeugt wird. Je konzentrierter bzw. je viskoser die Lösung ist, desto größer ist die damit erzielbare Schichtdicke. Insbesondere das Herstellen von höher konzentrierten Lösungen kann durch Erwärmen unterstützt und beschleunigt werden.

Ein weiterer Faktor, der das Herstellen einer PMMA-Schicht auf einem Substrat beeinflußt, ist die Oberflächenbeschaffenheit des Substrats. Eine zu hohe oder eine zu niedrige Oberflächenenergie des Substrats kann die Spreitung der PMMA-Schicht, also das Verlaufen der PMMA-Lösung auf dem Substrat negativ beeinflussen. Gegebenenfalls kann das Substrat daher vor der Aufbringung der PMMA-Schicht mit geeigneten oberflächenaktiven Substanzen vorbehandelt werden. Weitere zusätzlich zu ergreifende Maßnahmen können insbesondere bei Silizium- und Glassubstraten erforderlich sein. Dort können Haftungsprobleme auftreten, die bei dickeren PMMA-Schichten zum Ablösen derselben vom Substrat führen können. Abhilfe kann hier eine Vorbehandlung der Substratoberfläche mit einem Haftvermittler schaffen, zum Beispiel einem Detergenz. Besonders vorteilhaft für diesen Zweck haben sich Glycyrrhetinsäure· oder deren Glukoside erwiesen, welche vorteilhafterweise in einer 0,01 Gewichtsprozent enthaltenden Lösung in Ethanol oder Wasser angewendet werden. Durch die Vorbehandlung mit Glycyrrhetinsäure, einer den Steroiden verwandten Substanz, wird eine ausgezeichnete Haftung von mehr als 20 μm dicken PMMA-Schichten auf sämtlichen Substraten mit beliebig gestalteter Oberfläche erreicht. Auch bei weiteren Verfahrensschritten der Strukturierung der Substrate, insbesondere bei der Entwicklung, zum Beispiel galvanischen Prozessen, kommt es zu keinerlei Schichtablösungen.

Zudem wurde bei Elektronenbestrahlung dünner PMMA-Schichten (einige hundert Nanometer) gefunden, daß aus Milchsäure-Ethylesterlösung hergestellte PMMA-Schichten rückstandsfrei entwickelt werden, wogegen PMMA-Schichten aus Chlorbenzol-Lösung besonders bei Elektronenüberbelichtung durch den Entwicklungsprozeß nicht zu entfernende Rückstände aufweisen, wodurch der Erfolg weiterer Prozeßschritte gefährdet wird. Dies läßt sich dadurch erklären, daß selbst durch geringe Chlorbenzolrückstände im PMMA bei Elektronenbestrahlung Chlorradikale entstehen, die in Gegenwart von Sauerstoff zu peroxidischen Vernetzungsprodukten führen, welche im Entwicklungsprozeß nicht mehr auflösbar sind. Letzteres kann wesentlich dazu beitragen, daß zum Beispiel fehlerfreie Masken für die Röntgenlithographie nicht herstellbar sind.

Im folgenden wird das erfindungsgemäße Verfahren anhand eines Ausführungsbeispiels und der dazu gehörigen vier Figuren näher erläutert. Diese zeigen schematische Querschnitte durch ein elektrisches Bauteil und stellen verschiedene Verfahrensstufen bei der Herstellung desselben dar, wozu unter anderem eine PMMA-Schicht verwendet wird.

Ausführungsbeispiel:

Zunächst wird eine 1 Gewichtsprozent Poly-Methylmethacrylat enthaltende Lösung in Milchsäure-Ethylester hergestellt. Dazu wird PMMA-Granulat in Milchsäure-Ethylester eingerührt. Je nach Polymerisierungsgrad des PMMA kann zum Herstellen einer homogenen Lösung ein Erwärmen der Lösung erforderlich sein. Nach wenigen Minuten ist das PMMA vollständig aufgelöst.

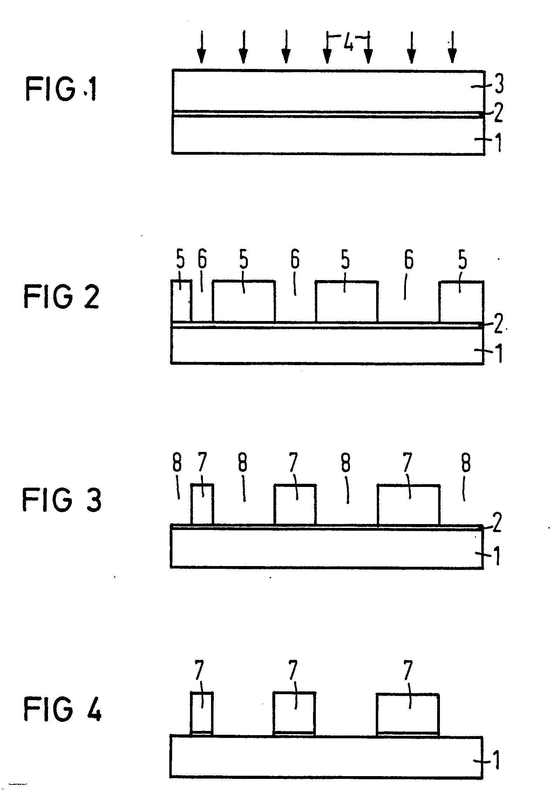

Figur 1: Ein halbleitendes Substrat 1, zum Beispiel Silizium, oder eine Aluminiumoxidkeramik ist mit einer dünnen Schicht eines Metalles, zum Beispiel mit 1 μm Kupfer, versehen. Auf dieses Substrat bzw. auf die Kupferschicht werden nun wenige Tropfen einer 0,01 Gewichtsprozent Glycyrrhetinsäure enthaltenden wäßrigen Lösung aufgeschleudert, um eine Haftvermittlerschicht zu erzeugen. Darauf wird nun die vorbereitete PMMA-Lösung aufgeschleudert. Je nach Viskosität dieser Lösung wird die Drehzahl so eingestellt, daß eine gleichmäßig dicke und homogene Schicht 3 erzeugt wird, zum Beispiel in einer Schichtdicke von 20 μm. Nach wenigen Minuten ist bei Raumtemperatur genügend Lösungsmittel abgedampft, bzw. die Schicht 3 ausreichend trocken, daß sie durch Aufschleudern von weiterer PMMA-Lösung problemlos verstärkt werden kann. Die beiden Teilschichten der Schicht 3 bilden eine homogene Gesamtschicht ohne erkennbare Übergänge. Auch Haftungsprobleme der Teilschichten untereinander treten nicht auf. Es wird schließlich eine insgesamt 40 μm dicke Schicht 3 erhalten. Diese wird nun ca. 1 Stunde bei Raumtemperatur getrocknet und schließlich röntgenlithographisch strukturiert. Dazu wird die Schicht 3 durch eine (nicht dargestellte) Kontaktmaske mit einer Röntgenstrahlung 4 belichtet. Durch die Maske werden dabei bestimmte Bereiche der Schicht 3 vor der Röntgenstrahlung 4 abgeschattet.

Figur 2: In den belichteten, nicht abgeschatteten Bereichen der Schicht 3 wird durch die Röntgenstrahlung das PMMA chemisch derart verändert, daß es sich im nachfolgenden naßchemischen Entwicklungsprozeß herauslöst. Es verbleiben die abgeschatteten Bereiche als Stege 5 auf der Kupferschicht 2 bestehen. Die herausgelösten Gräben 6 weisen steile Flanken auf. Die in den Gräben 6 freigelegte Kupferschicht 2 wird nun durch galvanische Abscheidung von Kupfer verstärkt und die Gräben 6 bis zur Oberkante der Stege 5 mit Kupfer aufgefüllt.

Figur 3 zeigt die den aufgefüllten Gräben (6) entsprechenden Kupferstrukturen 7, nachdem die Stege 5 durch Ätzen abgelöst wurden. In einem weiteren Ätzprozeß wird durch anisotropes Ätzen der gesamten Oberfläche soviel Kupfer abgetragen, bis die in den Gräben 8 freigelegte ursprüngliche Kupferschicht 2 entfernt ist.

Figur 4 stellt das Bauelement auf dieser Stufe dar. Auf dem Substrat 1 sind nur noch die Kupferstrukturen 7 verblieben, die ein positives Bild des in der Röntgenlithographie durch Belichtung erzeugten Musters darstellen. Derartige galvanoplastisch hergestellte Kupferstrukturen konnten bislang nur mit einer aufwendigen Photolacktechnik erzeugt werden. Mit dem erfindungsgemäßen Verfahren dagegen wird die Erzeugung von PMMA-Schichten bedeutend vereinfacht. Da so hergestellte PMMA-Schichten auch deutlich homogener sind, werden durch den Lithographieprozeß auch exaktere PMMA-Strukturen von bis zu 40 μm Dicke erzeugt, welche letztlich auch die Herstellung von exakteren Bauteilstrukturen, zum Beispiel galvanoplastisch erzeugten Metallstrukturen ermöglichen.

**Ansprüche**

1. Verfahren zur Erzeugung homogener Poly-Methylmethacrylat-Schichten 3 einstellbarer Dicke, welches folgende Verfahrensschritte aufweist:

a) Herstellen einer Lösung von Poly-Methylmethacrylat (PMMA) in Milchsäureester,

b) Aufbringen dieser Lösung in gleichmäßiger Schicht (3) auf einem Substrat (1, 2),

c) Trocknen dieser Schicht (3) durch Abdunsten des Lösungsmittels und

d) gegebenenfalls Wiederholen der Schritte b), c) und d).

2. Verfahren nach Anspruch 1, **dadurch gekennzeichnet,** daß Milchsäureethylester verwendet wird.

3. Verfahren nach Anspruch 1 oder 2, **dadurch gekennzeichnet,** daß die Dicke der Poly-Methylmethacrylat-Schicht (3) auf dem Substrat (1, 2) durch Einstellen der Poly-Methylmethacrylat-Konzentration in der Milchsäureesterlösung geregelt wird.

4. Verfahren nach mindestens einem der Ansprüche 1 bis 3, **dadurch gekennzeichnet,** daß die Poly-Methylmethacrylat-Schicht (3) durch Aufschleudern aufgebracht wird und die Schichtdicke durch Regeln der Drehzahl beim Aufschleudern eingestellt wird.

5. Verfahren nach mindestens einem der Ansprüche 1 bis 4, **dadurch gekennzeichnet,** daß die Oberfläche des Substrats (1, 2) vor dem Aufbringen der Schicht vorbehandelt wird.

6. Verfahren nach mindestens einem der Ansprüche 1 bis 5, **dadurch gekennzeichnet,** daß die Poly-Methyl methacrylat-Lösung weitere Komponenten enthält, die in Abhängigkeit von der Beschaffenheit der Substratoberfläche ausgewählt sind.

7. Verfahren nach mindestens einem der Ansprüche 1 bis 6, **dadurch gekennzeichnet,** daß die Poly-Methyl-Methacrylat-Lösung unter Erwärmen hergestellt wird.

8. Verfahren nach mindestens einem der Ansprüche 1 bis 7, **dadurch gekennzeichnet,** daß das Substrat vor dem Aufbringen der PMMA-Schicht mit Glycyrrhetinsäure oder deren Glukosiden vorbehandelt wird.

FIG 1

FIG 2

FIG 3

FIG 4